Europäisches Patentamt

European Patent Office

Office européen des brevets

(11) Veröffentlichungsnummer: **0 101 853**
**B1**

(12) **EUROPÄISCHE PATENTSCHRIFT**

(45) Veröffentlichungstag der Patentschrift: **19.12.90**

(21) Anmeldenummer: **83106800.2**

(22) Anmeldetag: **11.07.83**

(51) Int. Cl.⁵: **G 05 B 9/02,** B·61 L 1/20,
**G 08 G 1/097**

(54) Einrichtung zur potentialgetrennten Signalausgabe bei einem Steuerwerk.

(30) Priorität: **21.07.82 DE 3227290**

(43) Veröffentlichungstag der Anmeldung:
**07.03.84 Patentblatt 84/10**

(45) Bekanntmachung des Hinweises auf die
Patenterteilung:
**19.12.90 Patentblatt 90/51**

(84) Benannte Vertragsstaaten:
**AT CH DE FR GB LI NL SE**

(56) Entgegenhaltungen:
**CH-A- 594 340**
**FR-A-2 222 922**
**FR-A-2 381 075**

**RADIO FERNSEHEN ELEKTRONIK, Band 28, Nr.
5, 1979, Seite 327, Berlin, DE; W. MÜLLER:
"Thyristor-Vollweilensteuerung"
ELECTRONIQUE APPLICATIONS, Nr. 24, Juni-
Juli 1982, Seiten 29-34, Amsterdam, NL;
"Circuits de commande économiques pour
transistors SIPMOS"**

(73) Patentinhaber: **Siemens Aktiengesellschaft
Wittelsbacherplatz 2
D-8000 München 2 (DE)**

(72) Erfinder: **Eue, Wolfgang, Ing. (grad.)
Hagenring 22
D-3300 Braunschweig (DE)**

## Beschreibung

Die Erfindung bezieht sich auf eine Einrichtung zur potentialgetrennten Signalausgabe aus einem Steuerwerk mit Hilfe von aus Ein- und Ausgangselementen bestehenden Optokopplern des durch eine Stromversorgungseinrichtung gespeisten Steuerwerkes, das nur bei ordnungsgerechtem Betrieb ein diesen anzeigendes Kennsignal liefert.

Aus dem Buch "Optoelektronik kurz und bündig", Vogel-Verlag 1975, Kapitel 6.1.2 ist es bekannt, Optokoppler zur potentialgetrennten Signalausgabe in Prozeßrechnersystemen zu verwenden.

Wenn Steuerwerke, u.a. Prozeßrechnersysteme, in technischen Anlagen mit hohen Sicherheitsanforderungen, z.B. Eisenbahnsicherungsanlagen, eingesetzt werden, ist eine Überwachung der Steuerwerke auf ordnungsgerechten Betrieb erforderlich. Bei einer Fehlfunktion des Steuerwerkes muß der jeweilige technische Prozeß zur sicheren Seite hin beeinflußt werden. Die Überwachung kann beispielsweise in Form einer Selbstprüfung des Steuerwerkes durch Einsatz redundanter, sich gegenseitig vergleichender Systeme erfolgen. Ein ordnungsgerechter Betrieb des Steuerwerkes wird in jedem Fall zweckmäßigerweise durch ein andauerndes Kennsignal angezeigt. Nur beim Vorliegen dieses Kennsignales können die Ausgangssignale des Steuerwerkes bedenkenlos weitergeleitet werden. Daher müßte das Kennsignal mit jedem auszugebenden Signal durch ein sicheres UND-Glied kombiniert werden. Derartige Maßnahmen bedingen jedoch einen nicht unerheblichen technischen Aufwand.

In der Fachzeitschrift "Radio Fernsehen Elektronik", Band 28, Nr. 5, 1979, Seite 327, Berlin, DE ist eine Erläuterung der Thyristor-Vollwellensteuerung vorhanden. Die Schaltung wird zur Steuerung von Lampen oder Heizelementen in Belichtungszeitgebern bzw. Temperaturkonstanthaltern benötigt.

Aufgabe der Erfindung ist es, eine Einrichtung der eingangs genannten Gattung derart auszubilden, daß mit geringem technischen Aufwand eine sichere Verknüpfung zwischen den ausgangsseitigen Signalen des Steuerwerkes und dem Kennsignal erzielt wird.

Gemäß der Erfindung wird diese Aufgabe dadurch gelöst, daß zur Stromversorgung der Ausgangselemente aller Optokoppler ein galvanisch trennender, vom Kennsignal des Steuerwerkes speisbarer Umsetzer vorgesehen ist, der aus diesem Kennsignal eine Gleichspannung erzeugt, deren Größe von der electrischen Energie und/oder der Qualität des Kennsignals abhängig ist und die bei Ausfall des Kennsignals zu Null wird. Die galvanische Trennung verhindert dabei Verkettungen zwischen den von der Signalausgabe anzusteuernden Elementen und dem Steuerwerk. Dabei sind über die Optokoppler auch Analogsignale übertragbar.

Eine vorteilhafte Ausbildung der Erfindung ist dadurch gekennzeichnet, daß ein Umsetzer mit "fail-safe"-Verhalten verwendet ist. Dadurch wird erreicht, daß bei abgeschaltetem Kennsignal keine Versorgungsspannung an die Ausgangselemente der Optokoppler gelangt.

Eine weitere Ausbildung der erfindungsgemäßen Einrichtung sieht vor, daß die galvanische Trennung im Umsetzer über ein magnetisches Feld erfolgt. Damit ist eine relativ verlust freie Energieübertragung möglich.

Eine weitere vorteilhafte Ausbildung der Erfindung ist dadurch gekennzeichnet, daß ein Verstärker für das Kennsignal vorgesehen ist. Damit ist eine Anpassung der Stärke des Kennsignales an den Energiebedarf der Optpkoppler leicht möglich.

Wenn dem Ausgang des Umsetzers und/oder dem Ausgang jedes Optokopplers jeweils ein Entladewiderstand parallelschaltbar ist, ist sichergestellt, daß durch Kondensatoren im Umsetzer oder in den den Optokopplern nachgeschalteten Verarbeitungseinrichtungen keine Signalverfälschungen bewirkt werden.

Ein Ausführungsbeispiel der Erfindung ist in der Zeichnung dargestellt und wird im folgenden näher erläutert.

Dabei zeigen:

Figur 1 ein Blockschaltbild und

Figur 2 einen galvanisch trennenden Umsetzer.

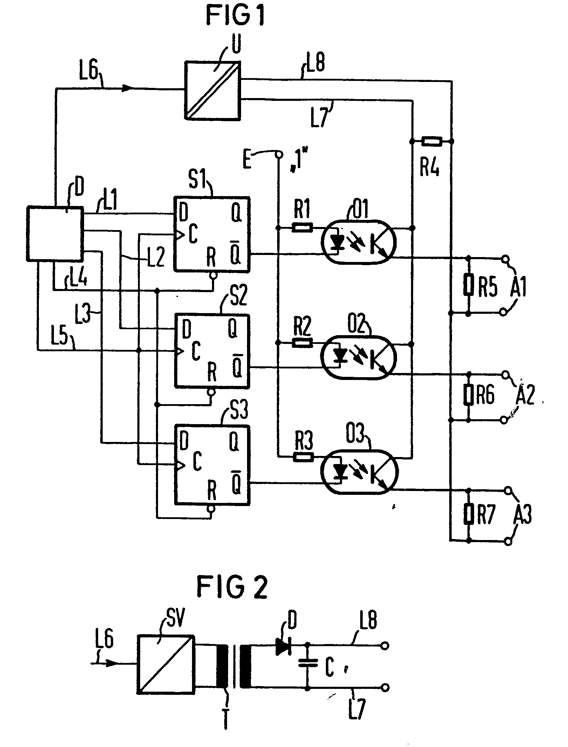

Die Darstellung gemäß Figur 1 zeigt als Steuerwerk eine Datenverarbeitungsanlage D. Diese gibt über Leitungen L1, L2 und L3 Daten an die D-Eingänge von drei Speichergliedern S1, S2 und S3 - jeweils nach Art eines D-Flip-Flops -. Die Daten werden dabei jeweils veranlaßt durch eine positive Taktflanke auf einer Leitung L4 in die Speicherglieder S1, S2 bzw. S3 übernommen. Über eine Leitung L5 kann bei Betriebsbeginn der Datenverarbeitungsanlage D aufgrund eines Signales logisch "0" jedes Speicherglied S1, S2 bzw. S3 in eine Grundstellung gesetzt werden.

Über eine Leitung L6 wird beim ordnungsgerechten Betrieb der Datenverarbeitungsanlage D ein Kennsignal an einen Umsetzer U geliefert. Der Umsetzer U formt aus diesem Kennsignal eine Gleichspannung. Der Ein- und der Ausgang des Umsetzers U sind dabei galvanisch voneinander getrennt. Der Umsetzer U weist "fail-safe"- Verhalten auf, d. h. ein Ausfall des Kennsignales führt zu einer Spannungsfreiheit am Ausgang des Umsetzers U. Das positive Potential der Ausgangsspannung vom Umsetzer U gelangt über eine Leitung L7 jeweils an den Kollektor von Fototransistoren der Optokoppler 01, 02 bzw. 03. Die Emitter dieser Fototransistoren führen an erste Pole von Ausgängen A1, A2 bzw. A3, die zu der Übersichtlichkeit halber nicht dargestellten Verarbeitungseinrichtungen fÜhren. Der jeweils zweite Pol jedes dieser Ausgänge A1, A2 bzw. A3 ist durch das negative Potential der Ausgangsspannung des Umsetzers U gegeben. Die Zuführung dieses Potentiales erfolgt über eine Leitung L8.

Dem Ausgang des Umsetzers U ist ein Entladewiderstand R4 parallelgeschaltet, dem Ausgang jedes Optokopplers 01, 02 bzw. 03 ist jeweils ein Entladewiderstand R5, R6 bzw. R7 parallelgeschaltet. Bei angenommener positiver Logik wird aufgrund des Vorliegens eines Signales logisch "1" an einem Eingang E jeweils über strombegrenzende Vorwiderstände R1, R2 und R3 ständig eine positive Spannung an die Anode jeweils einer jeweils einem der Optokoppler 01, 02 bzw. 03 zugeordneten Luminizenzdiode zugeleitet. Die Kathoden dieser Luminizenzdioden sind jeweils einem invertierenden Ausgang eines der Speicherglieder S1, S2 bzw. S3 zugeordnet. Damit fließt jeweils bei gesetztem Speicherglied S1, S2 bzw. S3 - logischer Zustand "0" am jeweiligen invertierenden Ausgang ein Strom über die jeweilige Luminizenzdiode des Optokopplers 01, 02 bzw. 03. Durch die Bestrahlung werden die zugeordneten Fototransistoren in den Optokopplern 01, 02 bzw. 03 leitend und am zugeordneten Ausgang A1, A2 bzw. A3 liegt bei ordnungsgemäßem Betriebszustand der Datenverarbeitungsanlage D ein Ausgangssignal vor.

Die Darstellung gemäß Figur 2 zeigt eine spezielle Ausbildung des Umsetzers U. Dieser erhält über die Leitung L6 das Kennsignal, das in einem Schaltverstärker SV verstärkt wird. Die Stromversorgung des Schaltverstärkers SV, die auch die Stromversorgung der Datenverarbeitungsanlage D und der Speicherglieder S1, S2 und S3 übernimmt, sowie den Eingang E mit Spannung versorgt, ist der Übersichtlichkeit halber nicht dargestellt. Das verstärkte Kennsignal, ein Taktsignal, gelangt an eine Primärwicklung eines Transformators T, dessen Sekundärwicklung galvanisch von der Primärwicklung getrennt ist. Das an der Sekundärwicklung anstehende transformierte Kennsignal wird durch eine Anordnung einer Diode D und eines Kondensators C gleichgerichtet. Die Weiterleitung des Gleichsignales erfolgt über die Leitungen L7 und L8.

## Patentansprüche

1. Einrichtung zur potentialgetrennten Signalausgabe aus einem Steuerwerk (D) an nachgeschaltete Verarbeitungseinrichtungen mit Hilfe von aus Ein- und Ausgangselementen bestehenden Optokopplern (01, 02, 03) des durch eine Stromversorgungseinrichtung gespeisten Steuerwerkes (D), das nur bei ordnungsgerechtem Betrieb ein diesen anzeigendes Kennsignal liefert, dadurch gekennzeichnet, daß zur Stromversorgung der Ausgangselemente aller Optokoppler (01, 02, 03) ein die Ausgangselemente von dem Steuerwerk (D) galvanisch trennender, vom Kennsignal des Steuerwerkes (D) steuerbarer Umsetzer (U) vorgesehen ist, der aus diesem Kennsignal eine Gleichspannung erzeugt, deren Größe von der elektrischen Energie und/oder der Qualität des Kennsignals abhängig ist und die bei Ausfall des Kennsignals zu Null wird.

2. Einrichtung nach Anspruch 1, gekennzeichnet durch die Verwendung eines Umsetzers (U) mit "fail-safe" Verhalten.

3. Einrichtung nach Anspruch 1 oder 2, dadurch gekennzeichnet, daß die galvanische Trennung im Umsetzer (U) über ein magnetisches Feld erfolgt.

4. Einrichtung nach einem der Ansprüche 1, 2 oder 3, dadurch gekennzeichnet, daß ein Verstärker (SV) für das Kennsignal vorgesehen ist.

5. Einrichtung nach einem der Ansprüche 1 bis 4, dadurch gekennzeichnet, daß dem Ausgang des Umsetzers (U) ein Entladewiderstand (R4) parallelschaltbar ist.

6. Einrichtung nach einem der Ansprüche 1 bis 5, dadurch gekennzeichnet, daß dem Ausgang jedes Optokopplers (01, 02, 03) ein Entladewiderstand (R5, R6, R7) parallelschaltbar ist.

## Revendications

1. Dispositif pour délivrer des signaux, avec séparation de potentiel, depuis une unité de commande (D) à des dispositifs de traitement branchés en aval à l'aide d'opto-coupleurs (01, 02, 03) constitués par des électrodes d'entrée et de sortie, de l'unité de commande (D), qui est alimentée par un dispositif d'alimentation en courant et fournit, uniquement dans le cas d'un fonctionnement correct, un signal caractéristique indiquant ce fonctionnement, caractérisé en ce que

pour l'alimentation en courant des éléments de sortie de tous les opto-coupleurs (01, 02, 03), il est prévu un convertisseur (Q), qui sépare galvaniquement les éléments de sortie par rapport à l'unité de commande (D) qui peut être commandé par le signal caractéristique de l'unité de commande (D) et qui produit, à partir de ce signal caractéristique, une tension continue dont la valeur dépend de l'énergie électrique et/ou de la qualité du signal caractéristique et s'annule dans le cas d'une absence du signal caractéristique.

2. Dispositif suivant la revendication 1, caractérisé par l'utilisation d'un convertisseur (Q) possédant un comportement "fail-safe".

3. Dispositif suivant la revendication 1 ou 2, caractérisé par le fait que la séparation galvanique est réalisée dans le convertisseur (U) par l'intermédiaire d'un champ magnétique.

4. Dispositif suivant l'une des revendications 1, 2 ou 3, caractérisé par le fait qu'il est prévu un amplificateur (SV) pour le signal caractéristique.

5. Dispositif suivant l'une des revendications 1 à 4, caractérisé par le fait qu'une résistance de décharge (R4) peut être branchée en parallèle avec la sortie du convertisseur (U).

6. Dispositif suivant l'une des revendications 1 à 5, caractérisé par le fait qu'une résistance de décharge (R5, R6, R7) peut être branchée en parallèle avec la sortie de chaque optocoupleur (01, 02, 03).

## Claims

1. Device for potential-isolated signal output from a control unit (D) to processing devices connected downstream with the aid of opto-couplers (01, 02, 03), consisting of input and output elements, of the control unit (D) fed by a current supply device which only in the case of satisfactory operation supplies a code signal indicating this, characterized in that, for the purpose of supplying the output elements of all the opto-couplers (01, 02, 03), a converter (U) which d.c. isolates the output elements from the control unit (D) and can be controlled by the code signal of the control unit (D) is provided which generates a d.c. voltage from this code signal, the magnitude of which depends on the electrical energy and/or the quality of the code signal and which becomes zero in the event of the failure of the code signal.

2. Device according to Claim 1, characterized by the use of a converter (U) with "fail-safe" characteristics.

3. Device according to one of Claims 1 and 2, characterized in that the d.c. isolation in the converter (U) occurs via a magnetic field.

4. Device according to one of Claims 1, 2 and 3, characterized in that an amplifier (SV) is provided for the code signal.

5. Device according to one of Claims 1 to 4, characterized in that a discharge resistor (R4) can be connected in parallel to the output of the converter (U).

6. Device according to one of Claims 1 to 5, characterized in that a discharge resistor (R5, R6, R7) can be connected in parallel to the output of each opto-coupler (01, 02, 03).

# FIG 1

# FIG 2